# EUROPEAN PATENT APPLICATION

(11) **EP 2 012 348 A1**
(43) Date of publication of application: **07.01.2009**
(21) Application number: 07737040.1
(22) Date of filing: 10.04.2007
(51) Int. Cl.: H01L 21/027, G03F 7/20

(54) **EXPOSURE APPARATUS**

(30) Priority: 25.04.2006 JP 2006120743
(71) Applicant: Nikon Corporation, Tokyo 100-8331 (JP)
(72) Inventor: KAWATA, Shintaro, Tokyo 1008331 (JP)
(74) Representative: Hooiveld, Arjen Jan Winfried
(86) International application number: PCT/JP2007/000383
(87) International publication number: WO 2007/129442

(57) **Abstract**

An exposure apparatus is equipped with a chamber, a dry-sealed vacuum pump, an evacuation duct and an infrared ray shielding section. The chamber accommodates components constituting the exposure apparatus therein. The dry-sealed vacuum pump evacuates gas in the chamber. The evacuation duct connects the chamber and the dry-sealed vacuum pump. The infrared ray shielding section is formed at least at an inlet part of the evacuation duct in the chamber or in the evacuation duct, and prevents incidence of infrared ray from the dry-sealed vacuum pump into the chamber.

## Description

### TECHNICAL FIELD

The present invention relates to an exposure apparatus operated under vacuum atmosphere.

### BACKGROUND ART

An EUV exposure apparatus using EUV light having wavelengths of about 1 to 50nm and a charged particle beam exposure apparatus using charged particle beams have been recently developed to enhance the resolution of an optical system restricted by diffraction limit of light with reduction of a size of a semiconductor integrated circuit (Patent Document 1 is shown as an example of the above exposure apparatus).

The EUV exposure apparatus and the charged particle beam exposure apparatus are respectively equipped with components such as a projection optical system, an original plate stage, a sensitive substrate stage, etc. These components are generally disposed inside a chamber under vacuum atmosphere in order to prevent EUV light and charged particle beams from being absorbed by air. A dry-sealed vacuum pump for vacuuming is coupled to the chamber through an evacuation duct.

Furthermore, in the above exposure apparatus, exposure precision is lowered when thermal deformation occurs in a wafer, a reticle, an optical element or the like in the exposure process. Therefore, it is necessary to perform temperature management on the respective components in the chamber with remarkably high precision.
Patent Document 1: Japanese Unexamined Patent Application Publication No. 2005-203754

### DISCLOSURE OF THE INVENTION

### PROBLEMS TO BE SOL VED BY THE INVENTION

The inventor of the present invention has analyzed various phenomena in the exposure process of the above exposure apparatus. As a result, the inventor has found that infrared ray generated by the dry-sealed vacuum pump is incident into the chamber through the evacuation duct and heats the components in the chamber.

The present invention is made to solve the problem of the above prior art, and has a proposition to provided an exposure apparatus that suppresses incidence of infrared ray from a dry-sealed vacuum pump into a chamber.

### MEANS FOR SOL VINC THE PROBLEMS

An exposure apparatus of the present invention has a chamber, a dry-sealed vacuum pump, an evacuation duct and an infrared ray shielding section. Components by which the exposure apparatus is made up are mounted in the chamber. The dry-sealed vacuum pump evacuates gas in the chamber. The evacuation duct connects the chamber and the dry-sealed vacuum pump. The infrared ray shielding section is formed to at least one of an inlet part of the evacuation duct in the chamber and inside the evacuation duct and thereby incidence of the infrared ray from the dry-sealed vacuum pump and the chamber is prevented.

### EFFECT OF THE INVENTlON

According to the exposure apparatus of the present invention, increase of temperature of the components of the exposure apparatus which is caused by incidence of infrared ray from the dry-sealed vacuum pump into the chamber can be suppressed.

### BRIEF DESCRIPTION OF THE DRAWINGS

Fig. 1 is a diagram showing a main part of an exposure apparatus according to a first embodiment.
Fig. 2 is a schematic diagram showing the overall construction of an EUV exposure apparatus.
Fig. 3 is an enlarged schematic diagram showing a surface state of an evacuation duct.
Fig. 4 is a diagram showing a main part of an exposure apparatus according to a second embodiment.
Fig. 5 is a diagram showing a main part of an exposure apparatus according to a third embodiment.
Fig. 6 is a diagram showing a main part of an exposure apparatus according to a fourth embodiment.
Fig. 7 is a plan view showing an example of the construction of a shielding member.
Fig. 8 is a A-A cross-sectional view of Fig. 7.
Fig. 9 is a diagram showing a modification of the construction of Fig. 6.
Fig. 10 is a diagram showing a main part of an exposure apparatus according to a fifth embodiment.
Fig. 11 is a schematic diagram showing the overall construction of a charged particle beam exposure apparatus.

### BEST MODE FOR CARRYING OUT THE INVENTION

### (Description of First Embodiment)

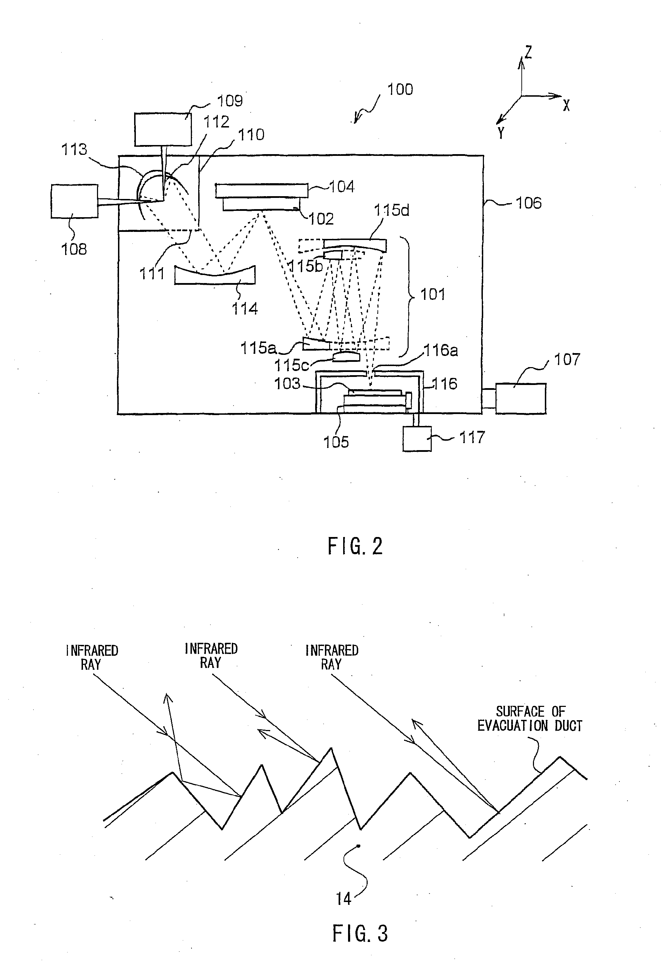

The construction of an exposure apparatus according to a first embodiment will be first described. First, the overall construction of an EUV exposure apparatus according to an example of the present invention will be schematically described with reference to Fig. 2.

The EUV exposure apparatus 100 shown in Fig. 2 uses EUV light as illumination light for exposure. The wavelength of the EUV light ranges from 0.1 to 400nm, however, this embodiment uses EUV light of about 1 to 50nm in wavelength. An image optical system 101 is used as the projection optical system. A pattern with which a wafer 103 is irradiated is determined by a reflection type reticle 102. A reduced image of a pattern based on the reticle 102 is formed on the wafer 103. The reticle 102 is disposed through an electrostatic chuck (not shown) at the lower side of a reticle stage 104. The wafer 103 is disposed on a wafer stage 105. Typically, light exposure is performed by step scan. The overall exposure apparatus is disposed in a clean room which is kept in a predetermined temperature range, and it is controlled so that the inside of the apparatus is also kept in a predetermined temperature range.

EUV light used as illumination light in the exposure process has low transmission performance to atmospheric air, and thus the optical path through which the EUV light passes is surrounded by a vacuum chamber 106 which is kept under vacuum by a vacuum pump 107. Furthermore, EUV light is generated by a laser plasma X-ray source. The laser plasma X-ray source includes a laser source 108 (acts as an exciting light source) and a xenon gas supply device 109. The laser plasma X-ray source is surrounded by the vacuum chamber 110, and EUV light generated by the laser plasma X-ray source passes through a window 111 of the vacuum chamber 110.

A paraboloid mirror 113 is disposed in the neighborhood of a xenon gas discharging section. The paraboloid mirror 113 constitutes a condensing optical system for condensing EUV light generated by plasma. The focus position of the paraboloid mirror 113 is adjusted to be located in the neighborhood of the position at which xenon gas from a nozzle 112 is discharged. The EUV light is reflected by multilayer film of the paraboloid mirror 113, passes through the window 111 in the vacuum chamber 110 and reaches a collection mirror 114. The collection mirror 114 condenses the EUV light and reflects it to the reticle 102. The EUV light is reflected from the collection mirror 114, and illuminates a predetermined position of the reticle 102. That is, the paraboloid mirror 113 and the collection mirror 114 constitute an illumination system of the exposure apparatus.

The reticle 102 has multilayer film for reflecting EUV light and an absorber pattern layer for forming a pattern. Reflection of EUV light at the reticle 102 makes a pattern of the EUV light. The patterned EUV light passes through the image optical system 101 and reaches the wafer 103.

The image optical system 101 in Fig. 2 includes four reflection mirrors of a concave first mirror 11 5a, a convex second mirror 11 5b, a convex third mirror 115c and a concave fourth mirror 115d. Each of the mirrors 115a to 115d is provided with multilayer film for reflecting EUV light.

EUV light reflected form the reticle 102 is successively reflected by the first mirror 115a to the fourth mirror 115d, and a reduced image of the pattern of the reticle 102 (for example, a reduction rate of 1 /4, 1 /5, 1/6) is formed. The image optical system 101 is set to as to be telecentric at the image side (at the side of the wafer 103).

The reticle 102 is supported within at least X-Y plane by a movable reticle stage 104. The wafer 103 is supported by a wafer stage which is preferably movable in X, Y, Z directions. When a die on the wafer 103 is exposed to light, a predetermined area of the reticle 102 is irradiated with EUV light by the illumination system. The reticle 102 and the wafer 103 are moved relatively to the image optical system 101 at a predetermined speed corresponding to the above reduction rate. As described above, a predetermined exposure range on the wafer 103 (to die) is exposed to the reticle pattern.

In the exposure process, the wafer 103 is preferably disposed in a wafer chamber behind a partition 116 so that gas occurring from a resist on the wafer 103 does not adversely affect the mirrors 115a to 115d of the image optical system 101. The partition 116 has an opening 116a, and the wafer 103 is irradiated with EUV light from the mirror 115d through the opening 116a. The space in the partition 116 is evacuated to vacuum by the vacuum pump 117. As described above, gaseous dust occurring in the exposure process is prevented from adhering to the mirrors 115a to 115d or the reticle 102, and thus the optical performance of these elements is prevented from being degraded.

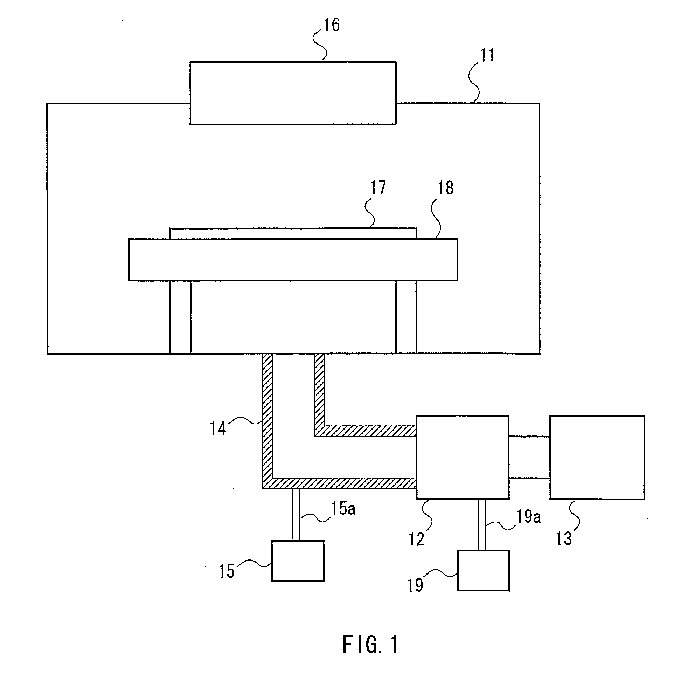

Returning to Fig. 1, a main part of the exposure apparatus according to the first embodiment will be described. For convenience of description, the wafer chamber in which the wafer and the wafer stage are mounted and an evacuation system for the wafer chamber (corresponding to 116 and 117 in Fig. 2) will be described with reference to Fig. 1. It is needless to say that the construction of the first embodiment may be applied to other elements such as the vacuum chamber in which the reticle and the image optical system are mounted and an evacuation system thereof (corresponding to 106 and 107 in Fig. 2).

The exposure apparatus of Fig. 1 has a vacuum chamber 11, a turbo pump 12, a mechanical pump 13, an evacuation duct 14, a duct cooler 1 5, a projection optical system 16, a wafer 17 and a wafer stage 18.

The wafer 17 and the wafer stage 18 are mounted in the vacuum chamber 11. An opening for leading EUV light from the projection optical system 16 to the wafer 1 7 is formed at the upper portion of the vacuum chamber 11. One end of the evacuation duct 14 is coupled to the lower portion of the wafer stage 18 in the vacuum chamber 11. The other end of the evacuation duct 14 is coupled to an intake port of the turbo pump 12. Furthermore, the evacuation duct 14 is cooled by the duct cooler 15 coupled to the evacuation duct 14 through a liquid cooling pipe 15a.

Furthermore, a mechanical pump 13 for rough evacuation is coupled to the exhaust port of the turbo pump 12 in series. The inside of the vacuum chamber 11 is kept under a high vacuum state of about 10⁻⁵Pa by driving the vacuum pumps 12, 13. The turbo pump 12 is cooled by a pump cooler 19 coupled to the turbo pump 12 through a liquid cooling pipe 19a.

Here, the evacuation duct 14 of the first embodiment is bent in an L-shape from one end side and intercommunicates with the other end side. Further, an infinite number of projections are formed on the inner surface of the evacuation duct 14 by a rough surfaced process such as roughening or the like. Therefore, the inner surface of the evacuation duct 14 constitutes an anti-reflection surface for preventing reflection of infrared ray described later. The height of the projections of the evacuation duct 14 (that is, the surface roughness of the inner surface of the evacuation duct 14) is properly set in accordance with the wavelength of infrared ray which is to be prevented from being reflected. As an example, in the first embodiment, the projection height of the inner surface of the evacuation duct 14 is set to about several µm to several mm. The above projections may be formed by means of being subject to surface processing such as screw cutting, or by means of being subject to coating silica sand or various kinds of ceramic powder mixed in base material on the inner surface of the evacuation duct 14.

The action of the exposure apparatus according to the first embodiment will be described hereunder. The turbo pump 12 is cooled by the pump cooler 19, however, infrared ray also occurs from a motor contained in the turbo pump during the operation of the turbo pump 12. This infrared ray is radiated through the evacuation duct 14 to the vacuum chamber 11.

However, the evacuation duct 14 is bent in L-shape as described above, and thus the direct radiation of the infrared ray from the turbo pump 12 to the vacuum chamber 11 is shielded. Furthermore, the inner surface of the evacuation duct 14 is designed as the anti-reflection surface on which the infinite number of projections are formed as described above. That is, infrared ray reflected from the inner surface of the evacuation duct 14 scatters intensely from the uneven surface made up of the projections. The repetition of reflection and absorption which are caused by the scattering remarkably reduces the amount of infrared ray reaching the vacuum chamber 11. Furthermore, the evacuation duct 14 is cooled by the duct cooler 15, and thus the evacuation duct 14 does not serve as a secondary heat source.

As described above, according to the construction of the first embodiment, the amount of infrared ray incident from the turbo pump 12 into the vacuum chamber 11 is remarkably reduced. As a result, thermal deformation of the wafer 17 which is caused by infrared ray from the turbo pump 12 is greatly suppressed.

### (Description of Second Embodiment)

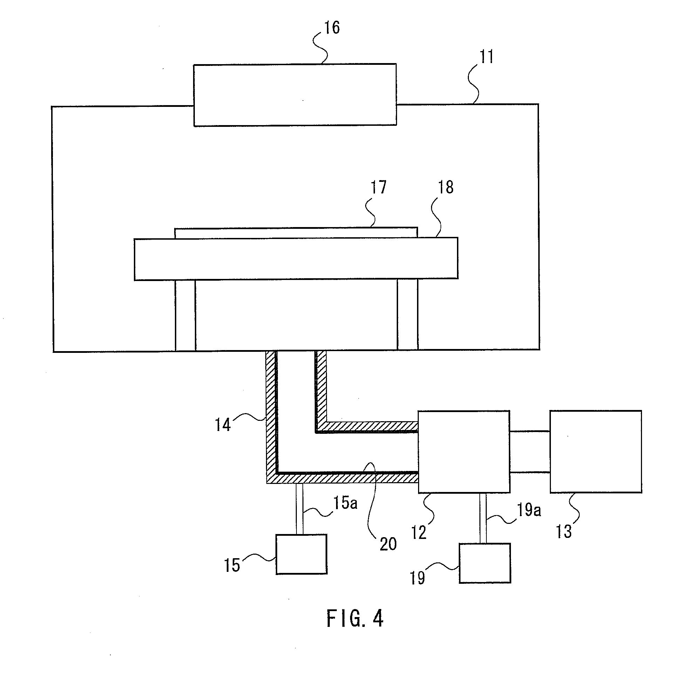

Fig. 4 is a diagram showing a main part of an exposure apparatus according to a second embodiment. Here, with respect to the constituent elements of the exposure apparatus of the following embodiments, the common constituent elements to the first embodiment are represented by the same reference numerals, and the duplicative description thereof is omitted.

In the second embodiment, anti-reflection film 20 for preventing reflection of infrared ray is formed on the inner surface of the evacuation duct 14. This anti-reflection film 20 is formed of a well-known infrared ray anti-reflection material. As an example, the anti-reflection film 20 is formed of a thin film material obtained by dispersing gold black, carbon black or metal oxide in polymer material. Furthermore, the evacuation duct 14 is cooled by the duct cooler 15, and thus the evacuation duct 14 does not serve as a secondary heat source. According to the construction of the second embodiment, substantially the same effect as the first embodiment can be obtained.

### (Description of Third Embodiment)

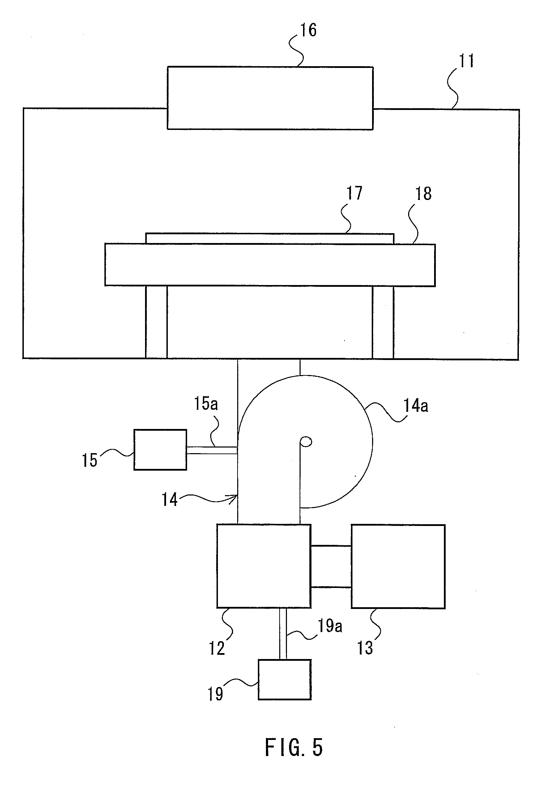

Fig. 5 is a diagram showing a main part of an exposure apparatus according to a third embodiment. In the third embodiment, a pipe line is bent and revolved at a middle portion of the evacuation duct 14 to form a revolving part 14, thereby forming a trap for infrared ray. The evacuation duct 14 is cooled by the duct cooler 15. According to the construction of the third embodiment, incidence of infrared ray from the turbo pump 12 into the vacuum chamber 11 is shielded, and thus substantially the same effect as the first embodiment can be obtained.

### (Description of Fourth Embodiment)

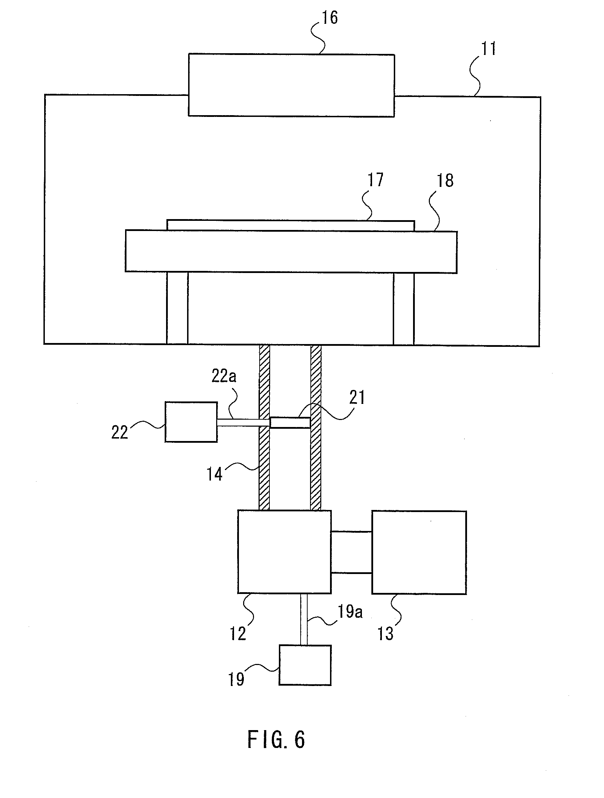

Fig. 6 is a diagram showing a main part of an exposure apparatus according to a fourth embodiment. In the fourth embodiment, a shielding member 21 for shielding infrared ray is disposed at a middle portion of the evacuation duct 14. The shielding member 21 is cooled by a cooler 22 coupled to the shielding member 21 through a liquid cooling pipe 22a. In the example of Fig. 6, the turbo pump 12 is disposed beneath the wafer stage 18, and no bending part is formed in the evacuation duct 14.

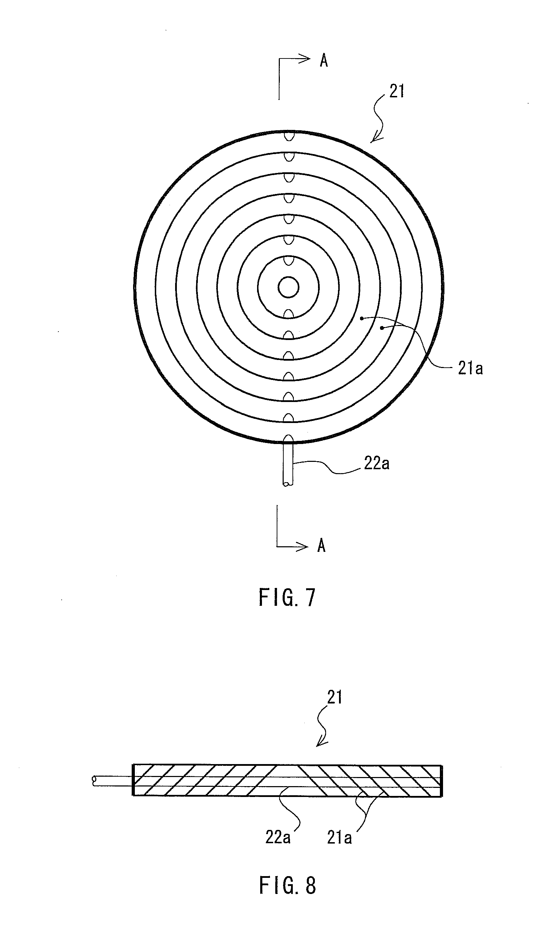

Figs. 7 and 8 show an example of the construction of the shielding member 21. The shielding member 21 is a plate-shaped member formed by concentrically disposing a plurality of circumferentially-shaped shielding vanes 21 a which are different in size. The size of the shielding member 21 is set so that the shielding member 21 is fitted into the inner diameter of the evacuation duct 14. The liquid cooling pipe 22a is disposed in the shielding member 21 so as to penetrate through the respective shielding vanes 21 a.

Furthermore, the respective shielding vanes 21 a are formed so that the diameter of each shielding vane 21a is increased from one end side thereof to the other end side thereof. The angle at which the diameter of the respective shielding vane 21a increases from one end side to the other end side in each shielding vane 21 a is set to be equal among the respective shielding vanes 21a. When viewed from a direction perpendicular to the shielding member 21 (from the upper side or lower side of Fig. 8), one end side and the other end side of adjacent shielding vanes 21 a are overlapped with the other end side and one end side thereof.

That is, under the assembly state of the shielding member 21, passage of infrared ray is intercepted by the plurality of shielding vanes 21 a which are arranged like a louver. Furthermore, a slit-shaped ventilation part is formed between the shielding vanes 21a, and gas flowing through the evacuation duct 14 can pass through the shielding member 21. The shielding member 21 is cooled by the cooler 22, and thus the shielding member 21 does not serve as a secondary heat source. Accordingly, according to the construction of the fourth embodiment, substantially the same effect as the first embodiment can be obtained. The construction of the shielding member 21 shown in Figs. 7 and 8 is an example, and the arrangement of the shielding vane 21a, etc. may be arbitrarily changed in accordance with the design.

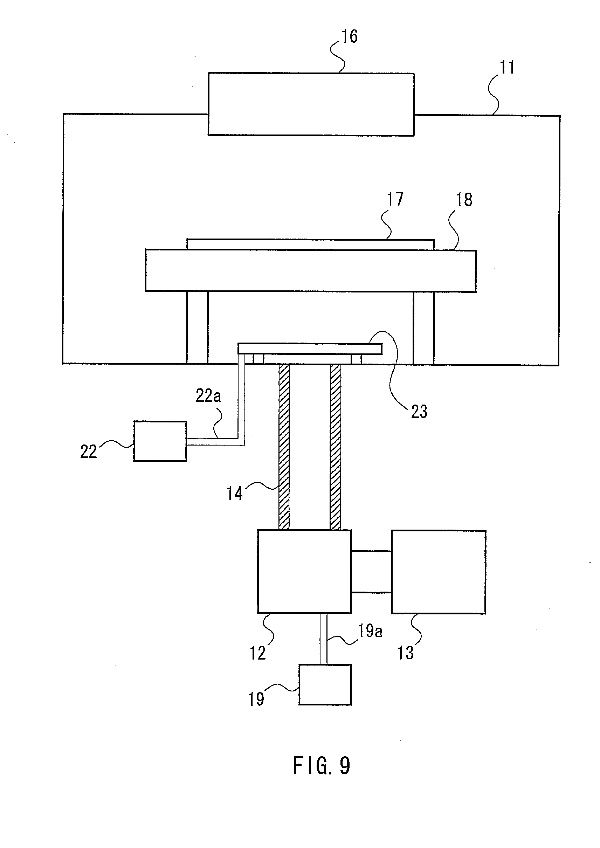

Fig. 9 shows a modification of the construction of Fig. 6 in the fourth embodiment. In Fig. 9, the shielding member 23 is provided at the inlet part of the evacuation duct 14 of the vacuum chamber 11. The shielding member 23 of Fig. 9 is cooled by the cooler 22 as in the example shown in Fig. 6. Furthermore, the shielding member 23 of fig. 9 includes a plate member having such a size it can shield the evacuation duct 14 and has no opening. In the example of Fig. 9, a clearance is provided between the shielding member 23 and the inlet of the evacuation duct 14. If the shielding member 21 shown in Figs. 7 and 8 is used in the example of Fig. 9, the shielding member 21 can be secured to the inlet part of the evacuation duct 14 with no clearance.

### (Fifth Embodiment)

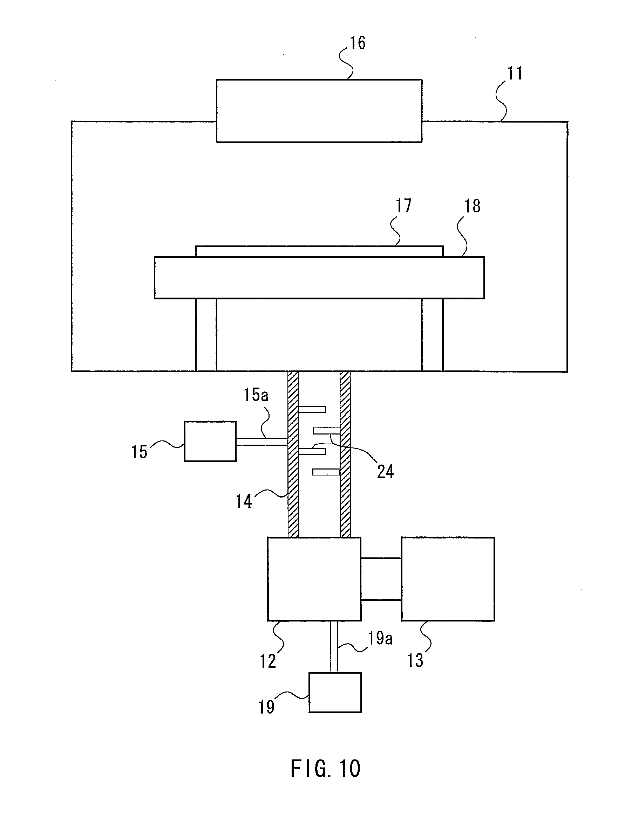

Fig. 10 is a diagram showing a main part of an exposure apparatus according to a fifth embodiment. In the fifth embodiment, the shielding structure having a plurality of projection pieces 24 is formed in the evacuation duct 14 is formed. The respective projection pieces 24 are arranged at different positions in the extension direction of the evacuation duct 14, and partially shield the evacuation duct 14. The plurality of projection pieces 24 are combined so that any projection piece 24 shields an area which any projection piece 24 does not shield, and set so that the whole of the evacuation duct 14 is shielded by the overall shielding structure. In the example of Fig. 10, each projection piece 24 shields a half or more area of the evacuation duct 14, and the plurality of projection pieces 24 are arranged so as to be alternately engaged with one another, thereby obtaining the shielding structure. Each projection piece 24 is preferably cooled by the duct cooler 15 or the like.

Furthermore, clearance is secured between the respective projection pieces 24, and the evacuation duct 14 is not perfectly shielded by the projection pieces 24, so that ventilation of the evacuation duct 14 is secured. The construction of the fifth embodiment can also obtain substantially the same effect as the first embodiment.

### (Description of Example and Comparative Examples)

Here, an example of the exposure apparatus of the construction according to the fourth embodiment shown in Fig. 6 will be described. In this example, the turbo pump was disposed at a distance of 1 m beneath the wafer stage in the EUV exposure apparatus, and also the shielding member was disposed in the evacuation duct. The vacuuming was carried out under the condition of 250L/min by the turbo pump. Furthermore, a managing target temperature of the wafer was set to 23°C, and the shielding member was cooled to 23°C. In this example, even when the wafer was left in the vacuum chamber for 10 minutes, the temperature increase of the wafer was kept below 0.1 °C.

As a comparative example of the above example, vacuuming was carried out under the same condition except that the shielding member was not provided, and the temperature of the wafer was measured. In this case, when the wafer was left in the vacuum chamber for 10 minutes, the temperature of the wafer was greatly increased to 23.9°C.

### (Supplemental Item of the Embodiments)

(1) In the above embodiments, the example of the EUV exposure apparatus is described. The present invention may be applied to a charged particle beam exposure apparatus. Here, the construction when the present invention is applied to the charged particle beam exposure apparatus will be schematically described.

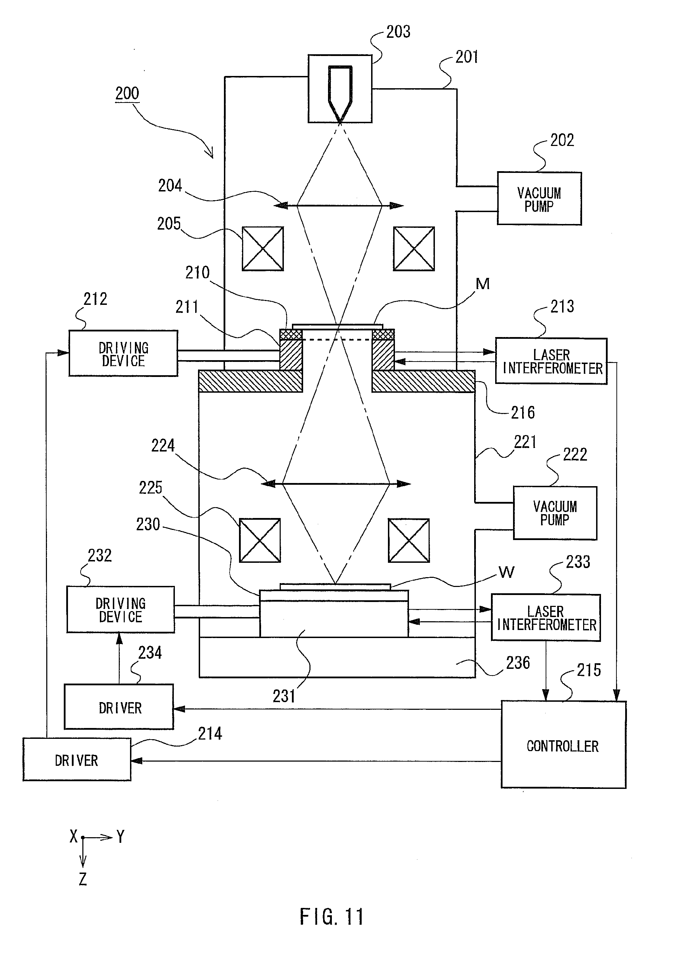

Fig. 11 is a diagram showing the overall construction of the charged beam exposure apparatus. The overall exposure apparatus is disposed in a clean room whish is kept in a predetermined temperature range, and the inside of the apparatus is controlled to be in a predetermined temperature range. An optical mirror barrel (vacuum chamber) 201 is disposed above the charged particle beam exposure apparatus 200. The vacuum pump 202 is coupled to the optical mirror barrel 201, and the inside of the optical mirror barrel 201 is evacuated to vacuum.

An electron gun 203 is disposed at the upper portion of the optical mirror barrel 201. The electron gun 203 emits electron beams to the lower side of the electron gun 203. A condenser lens 204, an electron beam deflector 205 and a mask M are successively disposed in this order at the lower side of the electron gun 203. The electron beams emitted from the electron gun 203 are converged by the condenser lens 204. Subsequently, the electron beams are successively scanned in the lateral direction in Fig. 11, thereby illuminating reach small area of the mask M in the visual field of the optical system.

The mask M is fixed with electrostatic adsorption or the like by a chuck 210 provided to the upper portion of the mask stage 211. The mask stage 211 is mounted on a surface table 216.

A driving device 212 shown at the left side of Fig. 11 is coupled to the mask stage 211. The driving device 212 is coupled to a controller 21 5 through a driver 214. A laser interferometer 21 3 is disposed at a side (right side of Fig. 11) of the mask stage 211. The laser interferometer 213 is coupled to the controller 21 5.

A wafer chamber (vacuum chamber) 221 is disposed at the lower side of the surface table 216. A vacuum pump 222 is coupled to a side (right side in Fig. 11) of the wafer chamber 221, and vacuum-evacuates the inside of the wafer chamber 221. A condenser lens 224, a deflector 225 and a wafer W are disposed from the upper side in the wafer chamber 221.

Electron beams passing through the mask M are converged by the condenser lens 224. The electron beams passing through the condenser lens 224 are deflected by the deflector 225, whereby an image of the mask M is formed at a predetermined position on the wafer W.

The wafer W is fixed with electrostatic adsorption or the like by a chuck 230 provided to the upper portion of the wafer stage 231. The wafer stage 231 is mounted on a surface table 236. A driving device 232 shown at the left side of Fig. 11 is coupled to the wafer stage 231. The driving device 232 is coupled to the controller 215 through a driver 234. A laser interferometer 233 is mounted at a side (right side of Fig. 11) of the wafer stage 231. The laser interferometer 233 is coupled to the controller 21 5.

By using the driving devices 212, 232 corresponding to the mask stage 211 and the wafer stage 231 respectively, the controller 215 drives the mask stage 211 and the wafer stage 231 to target positions in the exposure process based on position information obtained by the laser interferometers 21 3, 233.

In the charged particle beam exposure apparatus described above, the construction of the above embodiment can be applied to the parts corresponding to the vacuum chamber 201 and the vacuum pump 202 and the parts corresponding to the vacuum chamber 221 and the vacuum pump 222.

(2) The above embodiments are examples of the present invention, and the respective constructions of the first to fifth embodiments may be arbitrarily combined. For example, the shielding member shown in the fourth embodiment may be applied in a multiple-stage arrangement. Furthermore, as described above, the present invention is necessarily applicable to a vacuum chamber other than the wafer chamber in the EUV exposure apparatus and the charged particle beam exposure apparatus. In this case, by preventing infrared ray incident from the vacuum pump to the vacuum chamber, the thermal deformation of the mask, the reticle and the optical element can be suppressed.

The present invention can be implemented by various modifications without departing from the spirit thereof or the main features thereof. Therefore, the above-described embodiments are merely examples in every way and thus they should not be limitedly interpreted. The present invention is indicated by the scope of claims, and it is not restricted by the text of the specification. Furthermore, modifications and alterations encompassed in the equivalent range of the scope of claims are within the scope of the present invention.

## Claims

1. An exposure apparatus comprising:
a chamber in which components constituting the exposure apparatus are mounted;
a dry-sealed vacuum pump that evacuates gas in said chamber;
an evacuation duct through which said chamber and said dry-sealed vacuum pump are coupled to each other; and
an infrared ray shielding section that is formed at least at an inlet part of said evacuation duct in said chamber or in the evacuation duct, and prevents incidence of infrared ray from said dry-sealed vacuum pump into said chamber.

2. The exposure apparatus according to claim 1, wherein said infrared ray shielding section has a shielding structure in which said evacuation duct is shielded by a plurality of projection pieces so that ventilation can be performed.

3. The exposure apparatus according to claim 1, wherein said infrared ray shielding section is equipped with a ventilation part through which gas is passed, and has a shielding member that shields said evacuation duct.

4. The exposure apparatus according to claim 3, further comprising a cooler that cools said shielding member.

5. The exposure apparatus according to claims 1 to 4, wherein a bending part that shields direct irradiation of the infrared ray from said dry-sealed vacuum pump and is formed as said infrared ray shielding section in said evacuation duct.

6. The exposure apparatus according to any one of claims 1 to 5, wherein a plurality of projections that scatter the infrared ray are formed as said infrared ray shielding section on the inner surface of said evacuation duct.

7. The exposure apparatus according to claim 6, wherein said projections are formed by a rough surfaced process.

8. The exposure apparatus according to any one of claims 1 to 5, wherein anti-reflection film of the infrared ray is formed as said infrared ray shielding section on the inner surface of said evacuation duct.

9. The exposure apparatus according to any one of claims 1 to 5, wherein said infrared ray shielding section has a cooler that cools said evacuation duct.

10. The exposure apparatus according to any one of claims 1 to 9, wherein said exposure apparatus is an EUV exposure apparatus.

11. The exposure apparatus according to any one of claims 1 to 9, wherein said exposure apparatus is a charged particle beam exposure apparatus.
